# EUROPEAN PATENT APPLICATION

(11) **EP 0 928 116 A2**
(43) Date of publication of application: **07.07.1999**
(21) Application number: 98310643.6
(22) Date of filing: 23.12.1998
(51) Int. Cl.: H04N 7/64

(54) **Error correction encoding method and apparatus, data transmission method, receiving method and receiver**

(30) Priority: 29.12.1997 JP 36883997
(71) Applicant: SONY CORPORATION, Tokyo 141 (JP)
(72) Inventor: Shiomoto, Shoji, c/o Sony Corp., Tokyo (JP); Kugumiya, Mamoru, c/o Sony Corp., Tokyo (JP)
(74) Representative: Robinson, Nigel Alexander Julian

(57) **Abstract**

An encoding-multiplexing apparatus capable of reliably transmitting input data having high priority in accordance with priority information of input data and a receiver which decodes data transmitted from the encoding-multiplexing apparatus, in accordance with the priority information can be realized. In an outer encoding section (36), an error correction code having error correction ability according to the priority information of the input data is added to the input data in order to generate a fixed-length packet and moreover, said priority information is written in at a prescribed position of the fixed-length packet. Then, a plurality of packets are multiplexed and transmitted. The receiver extracts only a packet of a desired program from the plurality of packets and also, extracts priority information from the extracted packet, in order to perform a decoding based on the priority information.

## Description

This invention relates to an error correction encoding method and apparatus, a data transmission method, a receiving method and a receiver and more particularly, is suitably applied to an encoding method and apparatus, and a decoding method and apparatus which are used for a digital multiplex broadcasting system.

In a digital multiplex broadcasting system, a plurality of programs are compressed and encoded using the moving picture experts group phase 2 (MPEG2) method being a compressing and encoding method for image data. Then, these programs are multiplexed into one bit stream and transmitted. At this time, in this digital multiplex broadcasting system, a transmitting side performs an error correction coding on compression-coded image data and transmits it, and a receiving side performs an error correction decoding to correct errors generated in the middle of transmitting. Therefore, in the digital multiplex broadcasting system, even if the carrier-to-noise (C/N) ratio of a transmitted signal were degraded due to rain during transmission, the receiving side can correctly restore the transmitted signal.

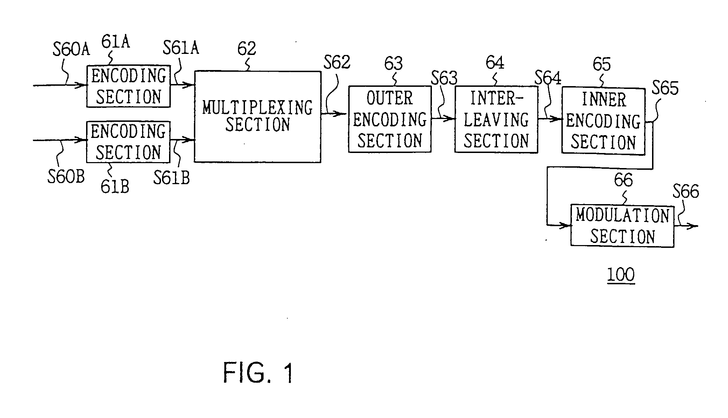

That is, in Fig. 1 reference numeral 100 denotes an encoding-multiplexing apparatus of the transmitting side, which is constructed of encoding sections 61A and 61B having the same structure, a multiplexing section 62, an outer encoding section 63, an interleaving section 64, an inner encoding section 65, and a modulating section 66. Image data S60A and S60B are inputted to the encoding sections 61A and 61B from the corresponding image data supply units (not shown) such as a video tape recorder respectively.

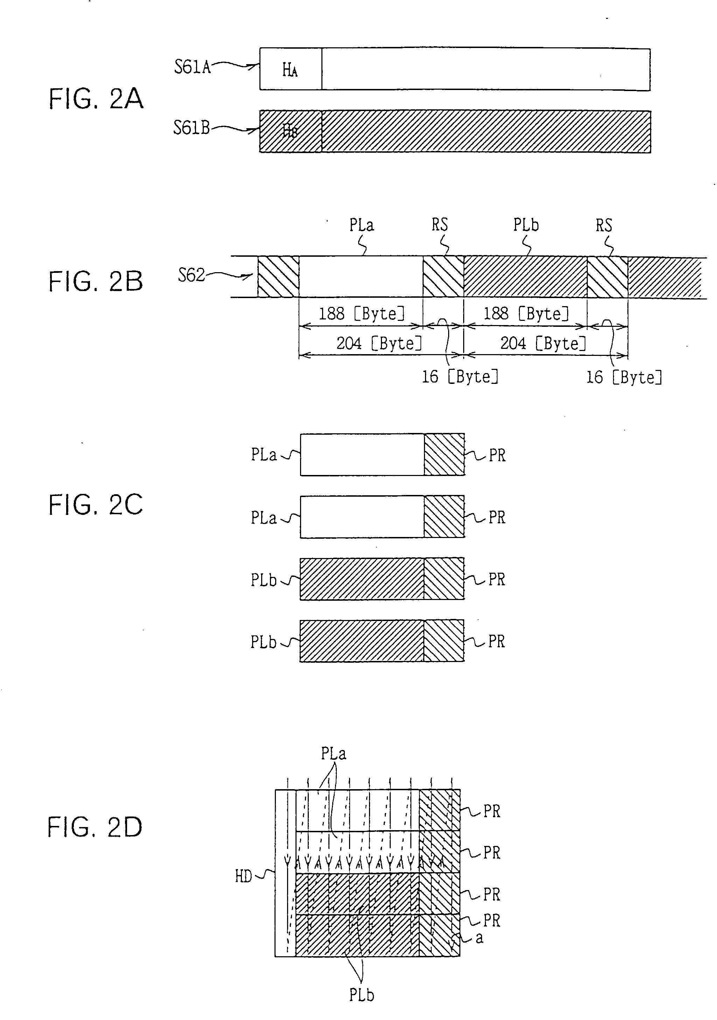

The encoding sections 61A and 61B compress and encode the image data S60A and S60B with the MPEG2 standard and supply them to the multiplexing section 62 as coded data S61A and S61B, respectively. The multiplexing section 62 divides the coded data S61A and S61B shown in Fig. 2A into fixed-length packets and then multiplexes the packets. That is, as shown in Fig. 2B, the multiplexing section 62 divides the coded data S61A and S61B, for example, into payloads PLa and PLb having a length of 188 bytes, respectively. Then, reserve regions RS are added to the payloads PLa and PLb to generate, for example, fixed-length packets of 204-byte length. The fixed-length packets are multiplexed and transmitted to the outer encoding section 63 as a coded stream S62. Here, the reserve region RS is a region for adding an outer code such as Read-solomon code. The outer code is a so-called block code that performs error correction in a block unit having a certain length.

The outer encoding section 63 adds parity PR being an outer code to the payloads PLa and PLb of the coded stream S62, as shown in Fig. 2C. This data is sent out to the interleaving section 64 as outer coded data S63. At this time, the parity PR is added at a position corresponding to the reserve region RS shown in Fig. 2B.

The interleaving section 64 performs a block interleaving process on the outer coded data S63 and transmits the resultant data to the inner encoding section 65 as interleaved data S64. That is, as shown in Fig. 2D, the interleaving section 64 writes the outer coded data S63 into a memory (not shown) thereof and adds a header HD. Then, the interleaving section 64 read out the outer coded data S63 with a block interleaving method as shown by an arrow a. By performing the aforementioned interleaving process, positions with errors are dispersed even in the case where transmission errors which intensively occur during transmission, i.e., burst errors occur. As a result, error correction ability can be enhanced.

In the inner encoding section 65, the interleaved data S64 is given an inner encoding process, such as a convolutional encoding, and transmitted to the modulating section 66 as inner coded data S65. In the modulating section 66, the coded data S65 is given a digital modulation process and supplied to a transmitter (not shown) as a transmission signal S66 to be transmitted. In this way, in the digital multiplex broadcasting system, the coded data S61A and S62B are given an error correction, such as Read-solomon coding or convolution coding, and transmitted. With this, even if the C/N ratio of the transmitted signal were degraded, the decoding side can restore a signal by performing the error correction, if the error occurring in the transmitted signal is less than a fixed threshold value.

Incidentally, in the aforementioned encoding-multiplexing apparatus 100, the error correction ability of the parity PR is fixed because the code length of the parity PR is fixed . Furthermore, in the convolution coding, the error correction ability fluctuates depending on the C/N ratio. Therefore, when the C/N ratio of a transmitted signal is less than a fixed threshold value, the apparatus 100 has a problem that reception will be suddenly interrupted at the receiving side.

This invention seeks to provide an error correction encoding method and apparatus, an error correction decoding method and apparatus, and a data transmission method in which input data having higher priority can be reliably transmitted in accordance with the priority of the input data.

At least preferred embodiments address these problems by the provision of an error correction encoding method and apparatus, an error correction decoding method and apparatus, and a data transmission method, in which input data is given an error correction code that has error correction ability according to the priority of the input data. With this, even in a state in which the transmission quality of a transmission path is degraded, input data having higher priority can be reliably transmitted.

Further, the input data is decoded in accordance with the priority at the receiving side, so that data having higher priority can be decoded even if the transmission quality of transmission path is degraded.

The nature, principle and utility of the invention will become more apparent from the following detailed description when read in conjunction with the accompanying drawings in which like parts are designated by like reference numerals or characters.

Embodiments of the invention will now be described, by way of example only, with reference to the accompanying drawings in which:
Fig. 1 is a block diagram showing the construction of an encoding-multiplexing apparatus;
Figs. 2A to 2D are schematic diagrams showing a multiplexing process;
Fig. 3 is a diagram showing the overall construction of a digital multiplex broadcasting system;
Fig. 4 is a block diagram showing the construction of an error correction encoding-multiplexing apparatus;
Figs. 5A to 5D are schematic diagrams explaining a multiplexing process;
Figs. 6 to 10 are block diagrams showing the construction of an error correction encoding-multiplexing apparatus according to other embodiments;
Figs. 11A to 11D are schematic diagrams explaining the multiplexing process according to another embodiment;
Figs. 12 to 16 are block diagrams showing the construction of an error correction encoding-multiplexing apparatus according to other embodiments;
Figs. 17A to 17F are schematic diagrams showing the example of using priority information;
Fig. 18 is a block diagram showing the construction of an error correction encoding-multiplexing apparatus according to another embodiment;
Fig. 19 is a schematic diagram showing the example of using priority information;
Fig. 20 is a block diagram showing the transmission of priority information; and
Fig. 21 is a block diagram showing the construction of a receiver·

Preferred embodiments of this invention will be described with reference to the accompanying drawings:

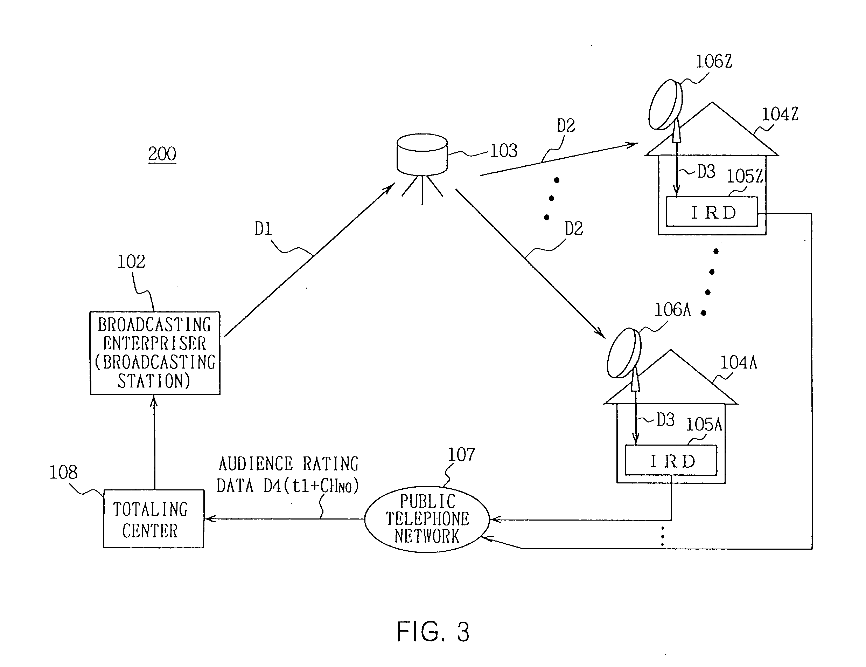

In Fig. 3, reference numeral 200 denotes a digital multiplex broadcasting system, in which a broadcasting enterpriser (broadcasting station) 102 compress and encodes image data and audio data with a prescribed encoding method, such as MPEG 2, and divides the data into packets to generate a transport stream. Then, the broadcasting enterpriser 102 packet-multiplexes the generated transport stream for plural channels, performs a prescribed modulating process on the obtained multiplexed bit stream, and transmits it to a communication satellite 103 as transmission data D1, for example, on a frequency of 10GHz.

The communication satellite 103, receiving the transmission data D1 transmitted, amplifies the transmission data D1 to data having a prescribed level by a transponder (not shown) and moreover, converts the frequency of the data D1 into, for example, a frequency of 1GHz, in order to generate transmission data D2. Then the communication satellite 103 transmits the data D2 to each of users' houses 104A to 104Z on the earth.

For example, an antenna 106A provided in the user's house 104A receives and decodes the transmission data D2, and transmits the resultant reception data stream D3 to a receiver (IRD) 105A. The IRD 105A multiplex-divides and decodes the reception data stream D3 in order to restore image data and audio data of a program, and displays image on a monitor (not shown) and outputs sounds with a speaker (not shown).

At this time, the IRD 105 stores an audience rating data into an internal memory as recording information on programs selected and watched by a user. When the audience rating data D4 is saved for one day, the IRD 105 automatically transmits the audience rating data D4 for one day to a totaling center 108 for an audience rating, via a public telephone network 107 at a fixed time, every day. Here, the audience rating data D4 is time information (t1) and channel number (CH_{NO}) of programs watched by a user.

The totaling center 108 obtains the audience rating for each program, based on all of the transmitted audience rating data D4 for one day transmitted from sample households (in this case, 15,000 households), and then inform the broadcasting enterpriser (broadcasting station) 102 of the audience rating resultant data D5.

Next, an error correction encoding-multiplexing apparatus in the digital multiplex broadcasting system 200 will be described.

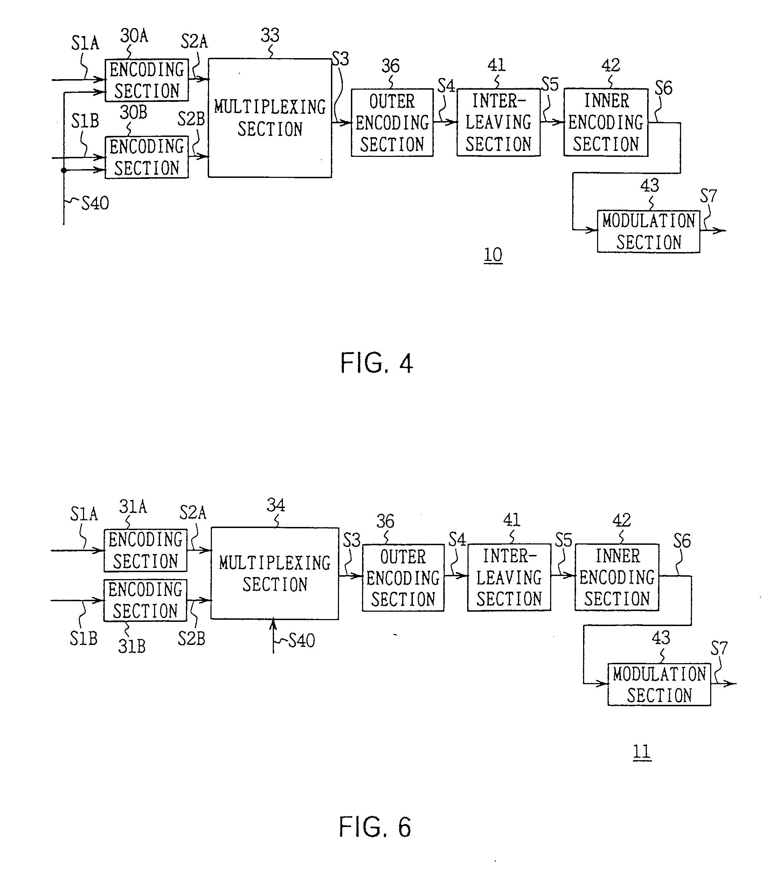

In Fig. 4 shows an error correction encoding-multiplexing apparatus 10 in the broadcasting station in Fig. 3, which is constructed of encoding sections 30A and 30B having the same structure, a multiplexing section 33, an outer encoding section 36, an interleaving section 41, an inner encoding section 42, and a modulating section 43.

Image data S1A and S1B different from each other are inputted to the respective encoding sections 30A and 30B from the corresponding image data supply units (not shown) such as video tape recorders. From a priority information supply section (not shown) that is controlled by an operator at the transmitting side, priority information S40, which represents the priorities of the image data S1A and S1B in a digital multiplex broadcasting system, is also supplied to the encoding sections 30A and 30B by control of the operator. In this embodiment, the image data S1B is higher in priority than the image data S1A.

The encoding section 30A compresses and encodes the image data S1A with MPEG2 standard so that the image data S1A has a quantity of generated code corresponding to the priority information S40. In this case, the priority information S40 allocates low priority to the image data S1A to be compressed and encoded in the encoding section 30A. Accordingly, the encoding section 30A performs compression-encoding on the image data S1A, for example, so as to obtain a high quantity of generated code. In this embodiment, the encoding section 30A transmits up to high order coefficients of the DCT coefficients generated in a DCT process, in accordance with the priority specified by the priority information S40 as encoding data, and also finely controls quantization step size, thereby increasing a quantity of generated code.

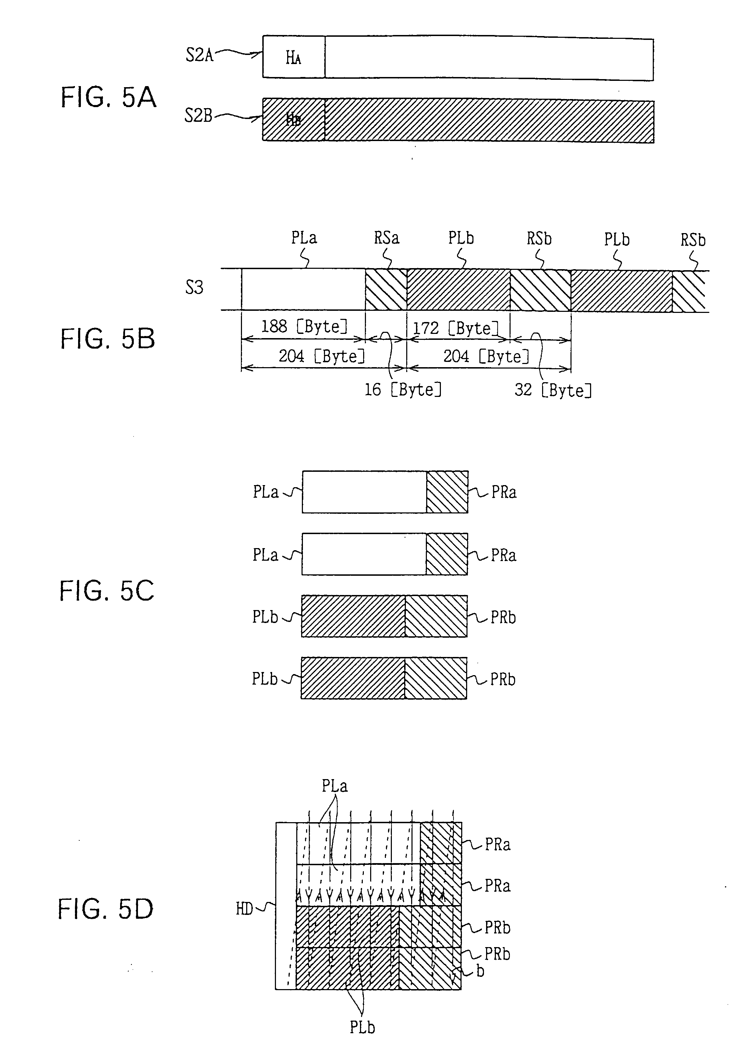

The image data S1A thus compressed and coded is given a header portion H_{A} for every data unit (e.g., one picture), as shown in Fig. 5A, and is transmitted to the multiplexing section 33 (Fig. 4) as coded data S2A. At this time, the encoding section 30A writes the priority, which is specified by the priority information S40, as user data in a private data region of the header portion H_{A} of the coded data S2A determined by MPEG2 standard. With this, the multiplexing section 33 can identify the priority of the coded data by reading out user data from the received coded data S2A.

Also, the encoding section 30B compresses and encodes the image data S1B with MPEG2 standard so that the image data S1B has a quantity of generated code according to the priority information S40. In this case, the priority information S40 allocates high priority to the image data S2B to be compressed and encoded in the encoding section 30B. Accordingly, the encoding section 30B performs the compression-encoding on the image data S1B, for example, so as to obtain a low quantity of generated code. In this embodiment, the encoding section 30B cuts down relatively higher order coefficients of the DCT coefficients generated in the DCT process, in accordance with the priority specified by the priority information S40, and also roughly controls quantization step size, thereby decreasing a quantity of generated code.

The image data S1B thus compressed and coded is given a header portion HB for every fixed data unit (e.g., one picture), as shown in Fig. 5A, and is transmitted to the multiplexing section 33 (Fig. 4) as coded data S2B. At this time, the encoding section 30B writes the priority, which is specified by the priority information S40, as user data in the private data region of the header portion H_{B} of the coded data S2B specified by MPEG2 standard. With this, the multiplexing section 33 can identify the priority of the coded data S2B by reading out the user data from the received coded data S2B.

The multiplexing section 33 divides the coded data S2A and S2B shown in Fig. 5A into fixed-length transport (TS) packets and then multiplexes the TS packets. At this time, the multiplexing section 33 controls the byte lengths of the payloads PLa and PLb obtained as the result of the dividing of the coded data S2A and S2B, based on the priority information S40 written in the header portions H_{A} and H_{B} of the coded data S2A and S2B. That is, as shown in Fig. 5B, the byte length of the payload PLb, which is obtained by dividing the coded data S2B having high priority, is generated so as to be shorter than that of the payload Pla, which is obtained by dividing the coded data S2A having low priority. In this embodiment, it is assumed that the byte length of the payload PLb is 172 bytes and the byte length of the payload PLa is 188 bytes. In this connection, each of the payloads PLa (188 bytes) and PLb (172 bytes) includes a TS header section having a fixed length newly added when the multiplexing section packetizes the coded data S2A and S2B.

Next, the multiplexing section 33 adds reserve regions to the payloads PLa and PLb in accordance with the lengths thereof so that the total length of the payload and the reserve region becomes constant. That is, the reserve region RSa having a length of 16 bytes is added to the payload PLa and the reserve region RSb having a length of 32 bytes is added to the payload PLb, thereby generating fixed-length packets having a length of 204 bytes. The fixed-length packets are multiplexed and transmitted to the outer encoding section 36 as a coded stream S3. In this connection, the lengths of the reserve regions RSa and RSb respectively added to the payloads PLa and PLb correspond to the lengths of parities PRa and PRb to be described later.

The outer encoding section 36 adds parities PRa and PRb being outer code of a Read-solomon encoding method to the reserve regions RSa and RSb of the coded stream S3, thereby forming a data array in which the parities PRa and PRb are added to the payloads PLa and PLb, as shown in Fig. 5C. This data array is transmitted to the interleaving section 41 as outer coded data S4 At this time, the outer encoding section 33 controls the error correction abilities of the parities PRa and PRb on the basis of the priority information S40. That is, the byte length of the parity PRb that is added to the payload PLb having high priority is lengthened to make the error correction ability higher, while the byte length of the parity PRa that is added to the payload PLa having low priority is shortened to make the error correction ability lower. Thus, parity with error correction ability according to the priority of image data is added.

The interleaving section 41, as shown in Fig. 5D, constitutes a frame by writing the outer coded data S4 in the memory (not shown), adds a header HD to the frame, and then reads out the outer coded data S4 in a block interleaving method as shown by an arrow b. In the header HD, the priority information of each packet (payload + parity) constituting the frame is written. A decoder of the receiving side decodes each packet in accordance with the priority.

By performing the aforementioned interleaving process, positions having errors are dispersed even in the case where transmission errors that intensively occur during transmission, i.e., burst errors occur. As a result, error correction ability can be enhanced.

The outer coded data S4 on which the block interleaving process was performed in the interleaving section 41 is transmitted to the inner encoding section 42 as interleaved data S5.

In the inner encoding section 42, the interleaved data S5 is given the error correction process by the inner encoding of a convolutional encoding method and transmitted to the modulating section 43 as inner coded data S6. In the modulating section 43, the inner coded data S6 is given a digital modulation process and supplied to a transmitter (not shown) as a transmission signal S7 to be transmitted.

Therefore, on the transmission signal S7 that is transmitted from the error correction encoding-multiplexing apparatus 10 onto a transmission path, two types of the image data (S1A and S2B) having error correction abilities different from each other according to their priorities have been multiplexed. As a result, even if the C/N ratio of the transmission signal S7 is reduced due to the transmission quality of the transmission path, at least the image data S1A having high error correction ability can reliably be reproduced at the receiving side.

In the error correction encoding-multiplexing apparatus 10 having the aforementioned construction, when the priority information S40 is supplied to the encoding sections 30A and 30B from the outside, each of the encoding sections 30A and 30B writes in the priorities according to the supplied priority information S40 at the header portion of each coded data as user data. In this way, the priority information is added to each coded data. Therefore, when coded data are outputted from the encoding sections 30A and 30B to the multiplexing section 33 and are multiplexed, the priorities can be easily identified only if the priority information is read out from each header portion.

The coded data, in which the priority thereof was identified, is given error correction ability by an outer code (parity) according to the priority. Therefore, even if transmission quality degrades in a transmission path, the coded data having high error correction ability (i.e., high priority) can be reliably reproduced at the reproducing side.

Also, the coded data, to which error correction ability according to priority has been added in an outer encoding section 36 of the error correction encoding-multiplexing apparatus 10, is interleaved by the interleaving section 41, in order to disperse the burst errors on a transmission path at the reproducing side. In this case, the code data inputted to the interleaving section 41 has been given the parity having a byte length which varies according to the priority. The packet length of the coded data, to which the variable parity was added, is equal to the total length of the payload and parity portions (204 bytes), so that the frame structure shown in Fig. 5D can be easily generated in the interleaving section 41. Thus, the interleaving process becomes simple.

According to the aforementioned construction, the error correction ability of the image data having high priority is made higher than that of the image data having low priority, so that the image data having high priority can reliably transmitted even in the case where the C/N ratio of the transmission signal is degraded by the signal attenuation accompanying with the quality degradation of the transmission path due to heavy rain or the like.

Note that, in the aforementioned embodiment, the quantity of generated code of the image data S1A having low priority is increased and the quantity of generated code of the image data S1B having high priority is decreased. However, the present invention is not limited thereto and the quantity of generated code according to priority can arbitrarily be set, for example, the quantity of generated code of the image data having high priority can be increased. In this case, when parity having a longer byte length is added to coded data having a large quantity of generated code, the coded data can be multiplexed at a higher rate as a multiplexing plan in the multiplexing section 33 or the transmission rate itself can be made high in a system capable of transmitting streams at a variable rate.

Also, in the aforementioned embodiment, two different priorities are given to two image data S1A and S1B by the priority information S40. However, the present invention is not limited thereto and the priorities to be given to the respective image data S1A and S1B can be selected from a plurality of priorities, for example, five levels. That is, the priority can be selected from various levels. In this case, the byte lengths of parities which are added to coded data in accordance with various priorities can be set to various lengths.

Also, in the aforementioned embodiment, the parity length to be added to coded data varies according to the priority information S40 supplied from the outside. However, the present invention is not limited thereto and the priority of the coded data having a small quantity of generated code can be made higher and the parity length to be added to the coded data can be lengthened, according to the quantity of code generated when the image data S1A and S1B to be inputted to the encoding sections 30A and 30B are encoded. Thus, the priorities can be determined by an internal process.

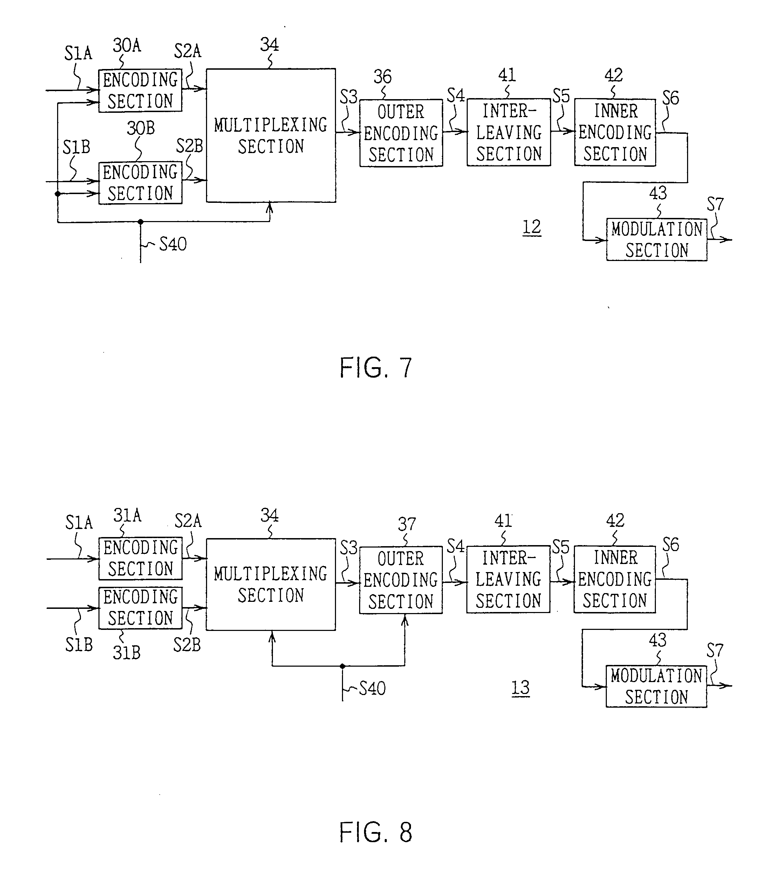

Also, in the aforementioned embodiment, the priority information S40 is supplied to the encoding sections 30A and 30B. However, the present invention is not limited thereto and as in an error correction encoding-multiplexing apparatus 11 shown in Fig. 6 in which the same reference numerals are applied to parts corresponding to Fig. 4, the priority information S40 can be supplied to a multiplexing section 34. That is, in accordance with the priority information S40 supplied from a priority information supply section (not shown), the multiplexing section 34 divides coded data S2A and S2B into data lengths according to priorities in the same manner as the case described in Fig. 5A, multiplexes and supplies the data to an outer encoding section 36 as a coded stream S3. At this time, the priority information S40 is written to the header portion (TS header) of each packet constituting the coded stream S3, so that parities PRa and PRb (Fig. 5C) according to priorities are added in the outer encoding section 36. The processes thereafter are the same as the error correction encoding-multiplexing apparatus 10 shown in Fig. 4. According to the error correction encoding-multiplexing apparatus 11 shown in Fig. 6, priorities are added to the coded data S2A and S2B by the multiplexing section 34, so that error correction abilities according to the priorities can be added to the coded data S2A and S2B.

Also, in the aforementioned embodiment, the priority information S40 is supplied to the encoding sections 30A and 30B. However, the present invention is not limited thereto and the priority information S40 can be supplied to encoding sections 30A and 30B and a multiplexing section 34 as an error correction encoding-multiplexing apparatus 12 shown in Fig. 7 in which the same reference numerals are applied to parts corresponding to Fig. 4. In this case, the encoding sections 30A and 30B encode image data S1A and S1B in accordance with the priority information S40 and moreover, the multiplexing section 34 divides the coded data S2A and S2B into data lengths according to priorities and adds reserve regions. Then, the same coded stream S3 as the case described in Fig. 5B is formed and transmitted to an outer encoding section 36. In this case, a TS header is added to each of packets according to the coded data S2A and S2B constituting the coded stream S3, and the priority information is written to the user regions of the TS headers as user data. With this, an outer encoding section 36, receiving the coded stream S3, adds the same parities PRa and PRb as the case described in Fig. 5C to the packets, so that error correction abilities according to the priorities can be added to the coded data S2A and S2B.

Also, in the aforementioned embodiment, the priority information S40 is supplied to the encoding sections 30A and 30B. However, the present invention is not limited thereto and the priority information S40 can be supplied to a multiplexing section 34 and an outer encoding section 37 as an error correction encoding-multiplexing apparatus 13 shown in Fig. 8 in which the same reference numerals are applied to parts corresponding to Fig. 4. In this case, as with the case described in Fig. 5B, the multiplexing section 34 divides the coded data S2A and S2B into data lengths according to priorities, adds prescribed reserve regions, and then multiplexes them to form and transmit a coded stream S3 to an outer encoding section 37. In the outer encoding section 37, parities of the byte lengths according to the priority information S40 are added to the packets of the coded data S2A and S2B multiplexed onto the coded stream S3, so that error correction abilities according to the priorities can be added to the coded data S2A and S2B.

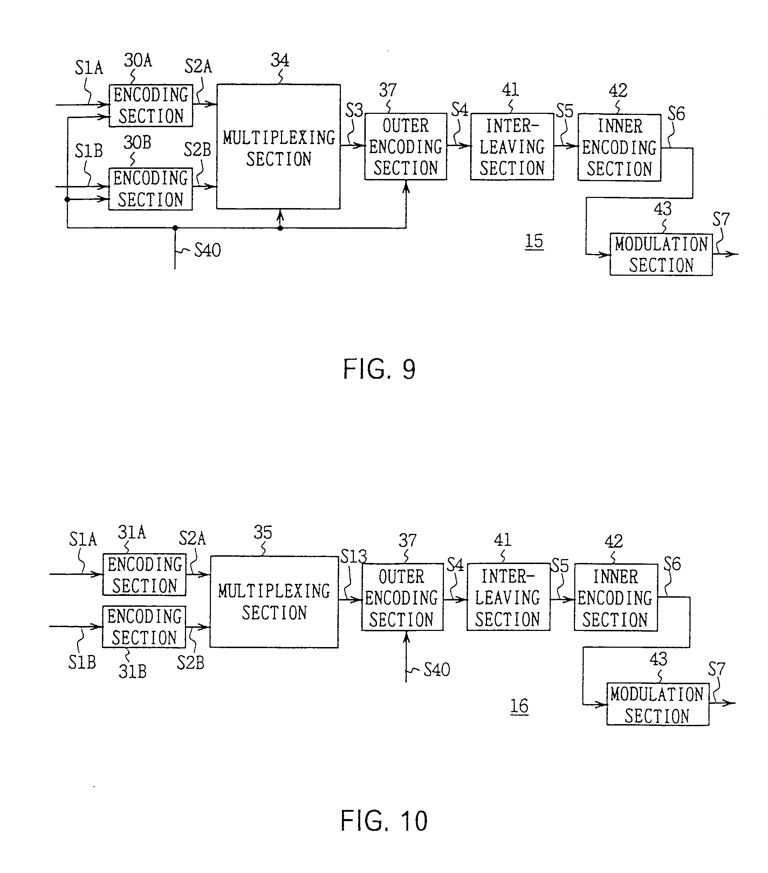

Also, in the aforementioned embodiment, the priority information S40 is supplied to the encoding sections 30A and 30B. However, the present invention is not limited thereto and the priority information S40 can be supplied to encoding sections 30A and 30B, a multiplexing section 34, and an outer encoding section 37 as an error correction encoding-multiplexing apparatus 15 shown in Fig. 9 in which the same reference numerals are applied to parts corresponding to Fig. 4. In this case, the encoding sections 30A and 30B encode image data S1A and S1B in accordance with the priority information S40 and moreover, the multiplexing section 34 divides the coded data S2A and S2B into data lengths according to priorities and adds reserve regions. With this, the same coded stream S3 as the case described in Fig. 5B is formed and transmitted to the outer encoding section 36. The outer encoding section 37 adds parities of the byte lengths according to the priority information S40 to the reserve regions of the packets of the coded data S2A and S2B multiplexed onto the coded stream S3. With this, error correction abilities according to the priorities can be added to the coded data S2A and S2B.

Also, in the aforementioned embodiment, the priority information S40 is supplied to the encoding sections 30A and 30B. However, the present invention is not limited thereto and the priority information S40 can be supplied only to an outer encoding section. That is, in Fig. 10 in which the same reference numerals are applied to parts corresponding to Fig. 4, reference numeral 16 generally denotes an error correction encoding-multiplexing apparatus, which is constructed of encoding sections 31A and 31B having the same structure, a multiplexing section 35, an outer encoding section 37, an interleaving section 41, an inner encoding section 42, and a modulating section 43.

Image data S1A and S1B are inputted to the encoding sections 31A and 31B from the corresponding image data supply units, such as video tape recorders (not shown). The encoding sections 31A and 31B compress and encode the respective image data S1A and S1B with MPEG2 standard, and supply the resultants to the multiplexing section 35 as coded data S2A and S2B respectively.

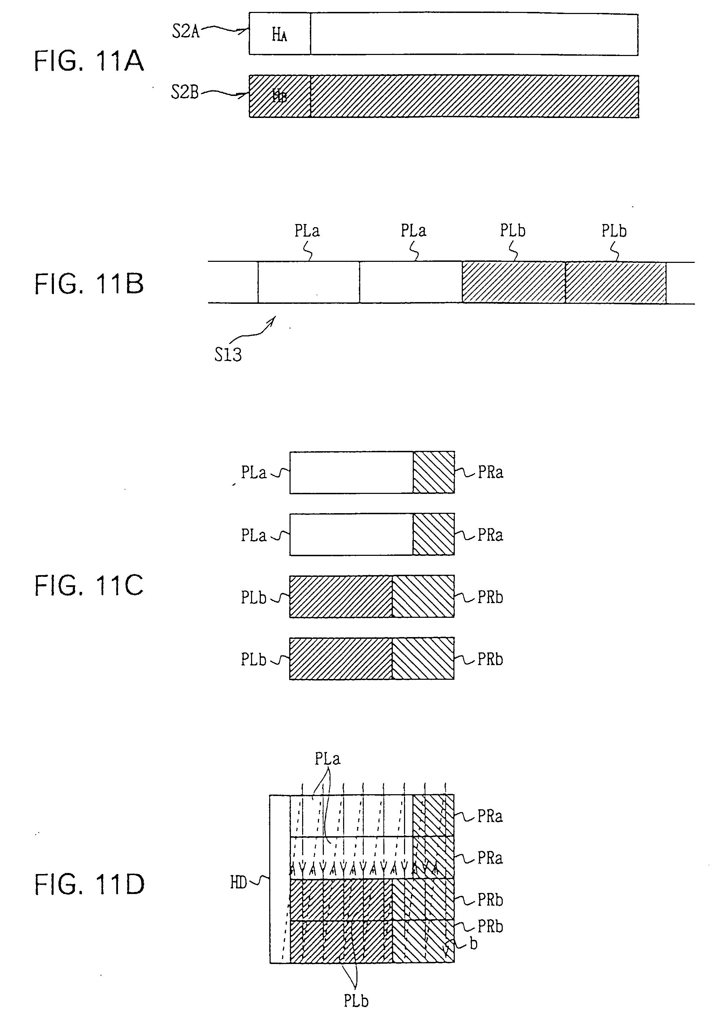

In Fig. 11A in which the same reference numerals are applied to parts corresponding to Fig. 5, the multiplexing section 35 divides the coded data S2A and S2B into fixed-length payloads PLa and PLb, respectively. After division, the payloads PLa and PLb are multiplexed and transmitted to the outer encoding section 37 (Fig. 10) as a coded stream S13 shown in Fig. 11B. Here, a priority information supply section (not shown) supplies priority information S40, which represents the priorities of the image data S1A and S1B in a digital multiplex broadcasting system, to the outer encoding section 37.

The outer encoding section 37 adds parities PRa and PRb being outer code such as Read-solomon code to the payloads PLa and PLb of the coded stream S13 and transmits them to the interleaving section 41 as outer coded data S4. At this time, the outer encoding section 37 controls the byte lengths of the payloads PLa and PLb and the parities PRa and PRb on the basis of the priority information S40. That is, as shown in Fig. 11C, the byte length of the payload PLb having high priority is made shorter than that of the payload PLa having low priority and the byte length of the parity PRb to be added to the payload PLb having high priority is shortened, whereby the error correction ability is made high. On the other hand, the byte length of the parity PRa to be added to the payload PLa having low priority is shortened to make the error correction ability lower. As a result, the total length of the payload and the parity is made constant. Thus, parity having error correction ability according to the priority of image data is added, maintaining a constant packet length.

In the interleaving section 41, the outer coded data S4 is given an interleaving process and transmitted to the inner encoding section 42 as interleaved data S5. That is, as shown in Fig. 11, the interleaving section 41 writes the outer coded data S4 in the memory (not shown) of the interleave section 41. After a header HD is added, the outer coded data S4 is read out with a block interleaving method, as shown by an arrow b. The processes thereafter are the same as the error correction encoding-multiplexing apparatus 10 shown in Fig. 4. According to the construction of the error correction encoding-multiplexing apparatus 16 shown in Fig. 10, the outer encoding section 37 adds priorities to the packets corresponding to the coded data S2A and S2B which constitute the coded stream S13. With this, error correction abilities according to the priorities can be added to the coded data S2A and S2B.

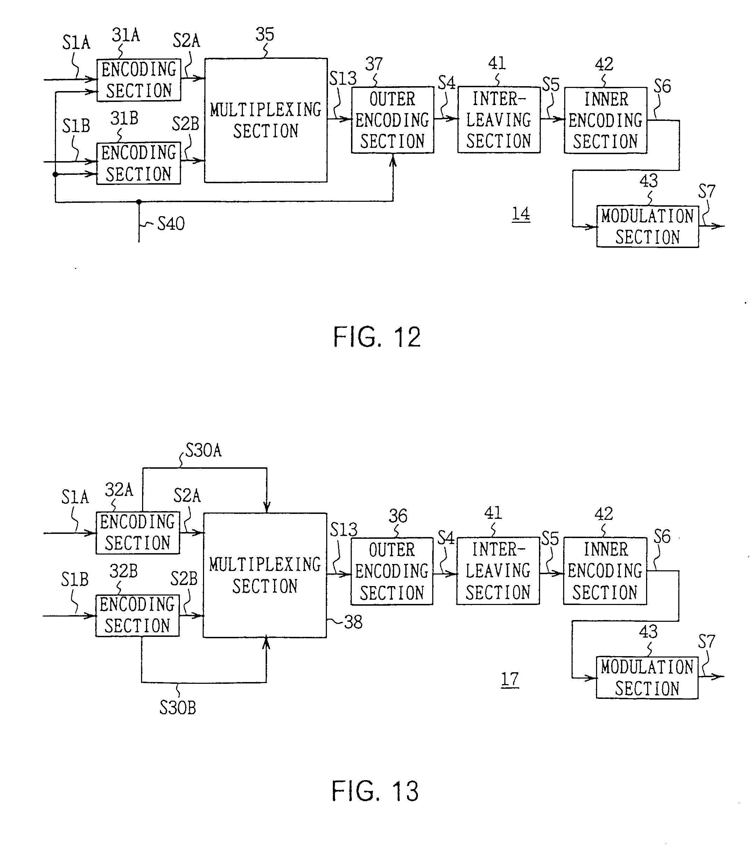

In this case, for example, as the error correction encoding-multiplexing apparatus 14 of Fig. 12 in which the same reference numerals are applied to parts corresponding to Fig. 10, the priority information S40 can be supplied to the encoding sections 31A and 31B in addition to the outer encoding section 37 so that the encoding sections 31A and 31B can perform an encoding according to each priority.

Also, in the aforementioned embodiment, the priority of each image data is determined based on the priority information S40. However, the present invention is not limited thereto and priority can be set for each encoding section, and the priority of each image data can be determined on the basis of the priority of each encoding section.

That is, in Fig. 13 in which the same reference numerals are applied to parts corresponding to Fig. 4, reference numeral 17 generally denotes an error correction encoding-multiplexing apparatus which is constructed of encoding sections 32A and 32B having the same structure, a multiplexing section 38, an outer encoding section 36, an interleaving section 41, an inner encoding section 42, and a modulating section 43.

Image data S1A and S1B are inputted to the encoding sections 32A and 32B from the respectively corresponding image data supply units, such as video tape recorders (not shown). The encoding sections 32A and 32B compress and encode the respective image data S1A and S1B with MPEG2 standard to supply them to the multiplexing section 38 as coded data S2A and S2B. At this time, the encoding sections 32A and 32B transmit priority information S30A and S30B, which represent the priorities of the encoding section 32A and 32B respectively, to the multiplexing section 38, respectively. The fixed priorities are previously allocated to the encoding sections 32A and 32B. As a result, For example, the priority of the encoding section 32B can be set higher than that of the encoding section 32A at all times. Also, in accordance with the image data S1A and S1B inputted to the encoding sections 32A and 32B, the encoding section 32A and 32B can set priorities according to the contents of images. In the case where priorities are set according to the contents of images, the priorities cab be determined according to the quantities of generated code when the image data S1A and S1B to be inputted to the encoding sections 32A and 32B are encoded. Also, image data S1A and S1B to be inputted can be previously given data representing priorities. Thus, various methods can be employed.

The multiplexing section 38 divides the coded data S2A and S2B into fixed-length packets and then multiplexes the packets. At this time, the multiplexing section 38 controls the byte lengths of the payloads PLa and PLb, which are obtained by dividing the coded data S2A and S2B, based on the priority information S30A and S30B. That is, as shown in Fig. 5B, in the multiplexing section 38, the byte length of the payload PLb, which is obtained by dividing the coded data S2B having high priority, is generated so as to be shorter than that of the payload Pla, which is obtained by dividing the coded data S2A having low priority. Furthermore, reserve regions according to the byte lengths of the payloads PLa and PLb are added to generate fixed-length packets in which the total length of the payload and reserve regions is constant. The fixed-length packets are multiplexed and transmitted to the outer encoding section 36 as a coded stream S3.

The outer encoding section 36 adds parities PRa and PRb being outer code of a Read-solomon method to the reserve regions of the payloads PLa and PLb of the coded stream S3 and transmits them to the interleaving section 41 as outer coded data S4. At this time, the outer encoding section 36 identifies the priorities of the payloads PLa and PLb in accordance with the byte lengths of the payloads PLa and PLb and sets the error correction abilities of the parities PRa and PRb in accordance with the priorities. Thus, error correction is performed according to the priority of each encoding section. The processes thereafter are the same as the error correction encoding-multiplexing apparatus 10 shown in Fig. 4.

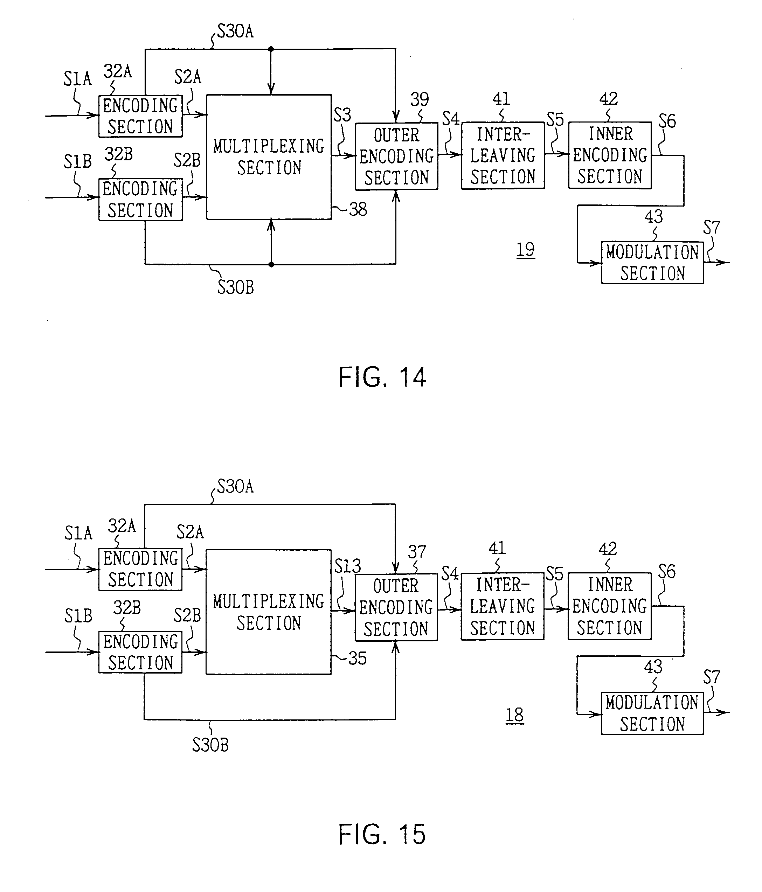

Also, in the error correction encoding-multiplexing apparatus 17 described in Fig. 13, the priority information S30A and S30B outputted from the encoding sections 32A and 32B respectively are supplied only to the multiplexing section 38. However, the present invention is not limited thereto and as shown in Fig. 14 in which the same reference numerals are applied to parts corresponding to Fig. 13, the priority information S30A and S30B outputted from the encoding sections 32A and 32B respectively can be supplied to the multiplexing section 38 and the outer encoding section 39.

In this case, the outer encoding section 39 adds parities PRa and PRb being outer code of a Read-solomon method to the reserve regions of the payloads PLa and PLb of the coded stream S3 (Fig. 5B), which is outputted from the multiplexing section 38, with error correction abilities (parity lengths) based on the priority information S30A and S30B. These data is sent out to the interleaving section 41 as outer coded data S4. Thus, error correction ability is added to each coded data in accordance with the priority information S30A and S30B that, which are outputted from the encoding sections 32A and 32B respectively.

Also, in the error correction encoding-multiplexing apparatus 17 described in Fig. 13, the priority information S30A and S30B outputted from the encoding sections 32A and 32B are supplied to the multiplexing section 38. However, the present invention is not limited thereto and as the error correction encoding-multiplexing apparatus 18 of Fig. 15 in which the same reference numerals are applied to parts corresponding to Figs. 10 and 13, the priority information S30A and S30B outputted from the encoding sections 32A and 32B can be supplied only to the outer encoding section 37.

In this case, the outer encoding section 37 adds parities PRa and PRb (Fig. 11C) having error correction abilities (parity lengths) according to the priority information S30A and S30B, to the payloads PLa and PLb of the coded stream S13 (Fig. 11B) outputted from the multiplexing section 35. These data is sent out to the interleaving section 41 as outer coded data S4. Thus, error correction ability is added to each coded data in accordance with the priority information S30A and S30B outputted from the encoding sections 32A and 32B.

Note that, in the aforementioned embodiments, the encoding sections 30A (31A, 32A) and 30B (31B, 32B) encode image data different from each other. However, the present invention is not limited thereto and the same image data can be encoded with different methods to generate a plurality of code data, and priorities can be set to the coded data.

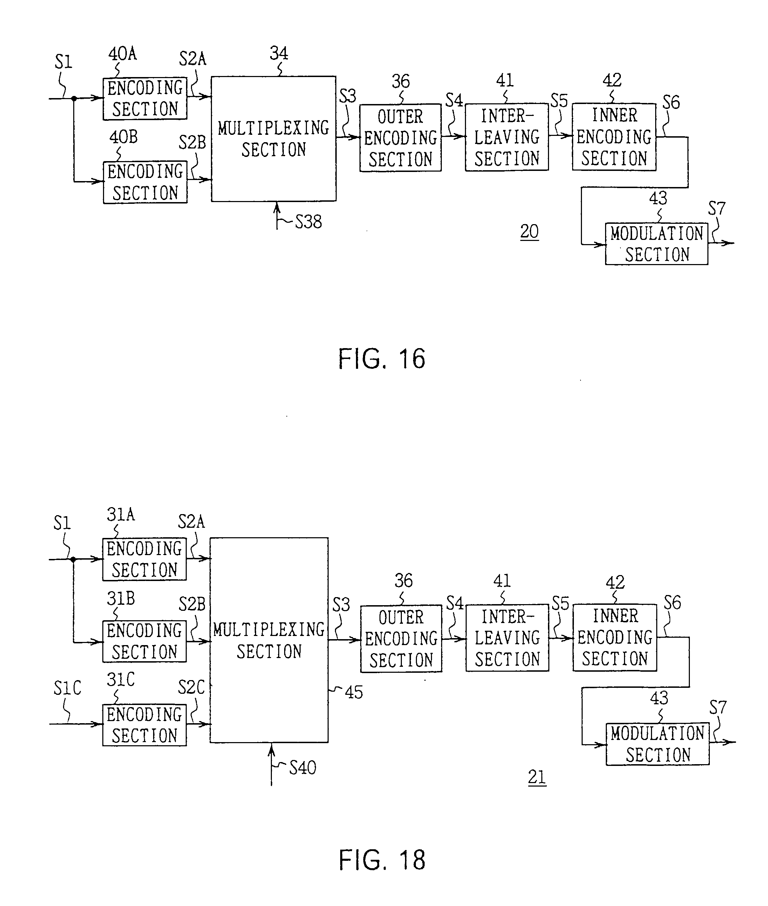

That is, in Fig. 16, reference numeral 20 generally denotes an error correction encoding-multiplexing apparatus, which is constructed of encoding sections 40A and 40B having the same structure, a multiplexing section 34, an outer encoding section 36, an interleaving section 41, an inner encoding section 42, and a modulating section 43. Image data S1 is inputted to the encoding sections 40A and 40B from an image data supply unit, such as a video tape recorder (not shown). The encoding sections 40A and 40B compress and encode the image data S1 with MPEG2 standard. The coded data are supplied to the multiplexing section 34 as coded data S2A and S2B. At this time, the encoding section 40A encodes the image data S1 with high definition television (HDTV) standard and transmits it to the multiplexing section 34 as coded data S2A. On the other hand, the encoding section 40B encodes the image data S1 with standard definition television (SDTV) standard and sends out it to the multiplexing section 34 as coded data S2B.

Priority information S40 is supplied from an priority information supply unit (not shown) to the multiplexing section 34. In the priority information S40, the priority of the coded data S2B, which is obtained by encoding the image data S1 with the SDTV standard, is set higher than that of the coded data S2A, which is obtained by encoding the image data S1 by the HDTV standard. The multiplexing section 34 divides the coded data S2A and S2B into fixed-length packets and then multiplexes the packets. At this time, the multiplexing section 34 controls the byte lengths of the payloads PLa and PLb obtained as the result of dividing the coded data S2A and S2B, based on the priority information S40. That is, as shown in Fig. 5B, in the multiplexing section 34, the byte length of the payload PLb, which is obtained by dividing the coded data S2B having high priority, is generated so as to be shorter than that of the payload Pla, which is obtained by dividing the coded data S2A having low priority. Furthermore, reserve regions according to the byte lengths of the payloads PLa and PLb are added to generate fixed-length packets in which the total length of the payload and reserve regions is constant. The fixed-length packets are multiplexed and sent out to the outer encoding section 36 as a coded stream S3. At this time, the priority information S40 is written to the header portion of the coded stream S3.

The outer encoding section 36 adds parities PRa and PRb being outer code of a Read-solomon method, to the payloads PLa and PLb of the coded stream S3 and sends out them to the interleaving section 41 as outer coded data S4. At this time, the outer encoding section 36 controls the error correction abilities of parities PRa and PRb on the basis of the priority information S40. That is, the byte length of the parity PRb which is added to the payload PLb having high priority is lengthened to make the error correction ability higher, while the byte length of the parity PRa which is added to the payload PLa having high priority is shortened to make the error correction ability lower. Thus, parity having error correction ability according to the priority of broadcasting data is added.

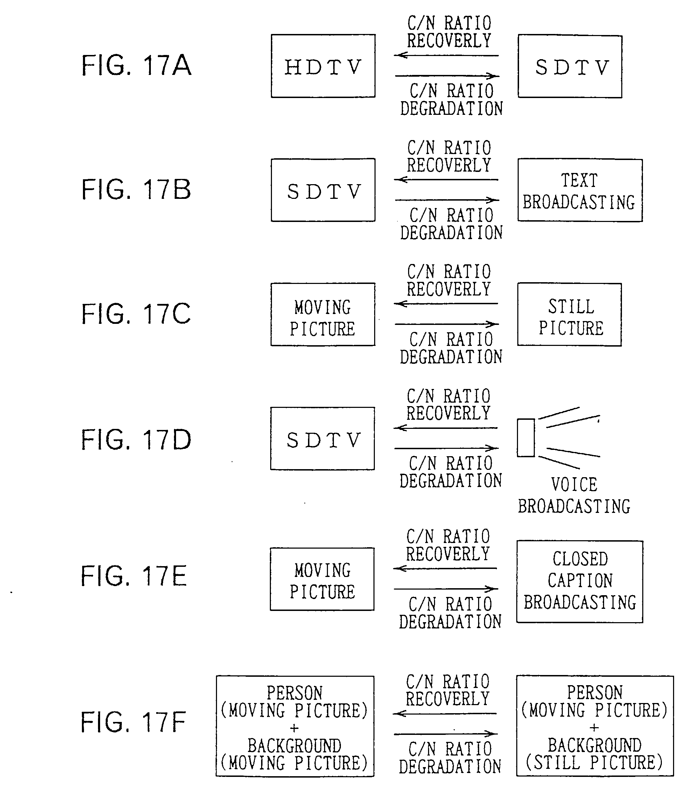

Here, the parity PRb, which is added to the coded data S2B obtained by encoding the image data S1 with the SDTV standard, is higher in error correction ability than the parity Pra, which is added to the coded data S2A obtained by encoding the image data S1 with the HDTV standard. Therefore, even in the case where the C/N ratio of the transmission signal is degraded by the signal attenuation accompanying with the quality degradation of the transmission path due to a heavy rain and the like and therefore the coded data S2A of HDTV standard cannot be decoded at the receiving side, the coded data S2B of SDTV standard can be decoded. That is, as shown in Fig. 17A, the coded data S2A of HDTV standard is normally decoded at the receiving side. When the C/N ratio is degraded and therefore the coded data S2A of HDTV standard cannot be decoded, the coded data S2B of SDTV standard having higher error correction ability is decoded. With this, the influence of the quality degradation of the transmission path is only a reduction in the quality of a decoded image, and interruption of reception due to the quality degradation of the transmission path can be prevented.

Further, in the aforementioned embodiment, image data are respectively inputted to the encoding sections 30A (31A, 32A, 40A) and 30B (31B, 32B, 40B). However, the present invention is not limited thereto and various broadcasting data other than image data can be input. That is, as shown in Fig. 17B, image data of SDTV standard and text-broadcasting data are inputted, and the priority of the text-broadcasting data is set high. Therefore, even in the case where the C/N ratio of the transmission signal is degraded by the signal attenuation accompanying with the quality degradation of the transmission path due to a heavy rain or the like and therefore the image data of SDTV standard cannot be decoded at the receiving side, the text-broadcasting data can be decoded. With this, an emergency broadcast and the like can be broadcast with using the aforementioned text-broadcasting data. Similarly, as shown in Fig. 17C, in a combination of moving picture data and still picture data, the priority of the still picture data can be made higher. As shown in Fig. 17D, in a combination of SDTV-standard image data and voice broadcasting data, the priority of the voice broadcasting data can be made higher. As shown in Fig. 17E, in a combination of moving picture data and closed caption data, the priority of the closed caption data can be made higher. As shown in Fig. 17F, in a combination of moving picture data (person (moving picture) + background (moving picture)) and image data (person (moving picture) + background (still picture)), the priority of the image data (person (moving picture) + background (still picture)) can be made higher. Thus, the present invention is applicable to various combinations of data to be encoded and various priorities.

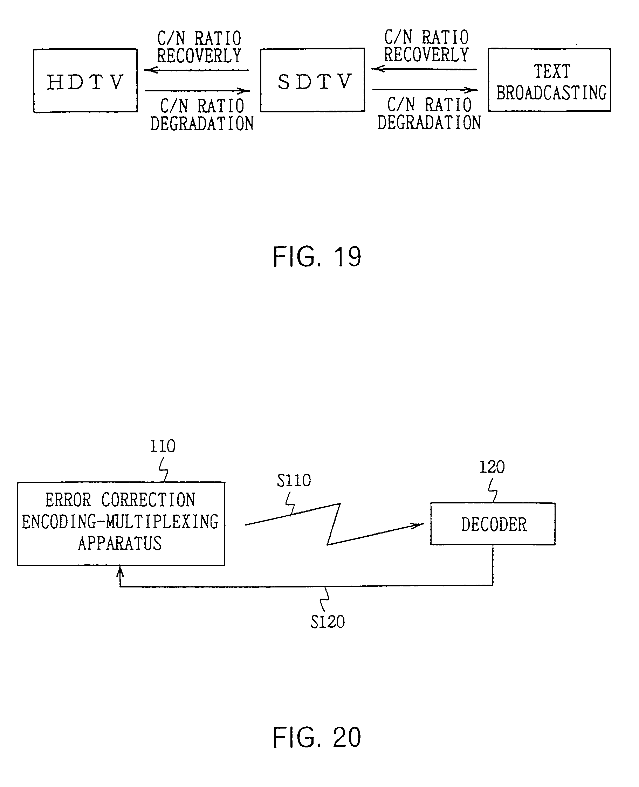

Also, in the aforementioned embodiments, the error correction encoding-multiplexing apparatus 10 has two encoding sections 30A (31A, 32A, 40A) and 30B (31B, 32B, 40B). However, the present invention is not limited thereto and the error correction encoding-multiplexing apparatus 10 can have two or more encoding sections. That is, in Fig. 18 reference numeral 21 generally denotes an error correction encoding-multiplexing apparatus, which is constructed of three encoding sections 31A to 31C having the same structure, a multiplexing section 45, an outer encoding section 36, an interleaving section 41, an inner encoding section 42, and a modulating section 43. Image data S1 is inputted to the encoding sections 31A and 31B from an image data supply unit, such as a video tape recorder (not shown). The encoding section 31A encodes the image data S1 with the HDTV standard in the MPEG2 standard and transmits it the multiplexing section 45 as coded data S2A. The encoding section 31B encodes the image data S1 with the SDTV standard in the MPEG2 standard and transmits it to the multiplexing section 34 as coded data S2B. Furthermore, text-broadcasting data S1C is supplied to the encoding section 31C from a text-broadcasting data supply unit (not shown). The encoding section 31A encodes the image data S1 with MPEG2 standard and sends out the coded data to the multiplexing section 45 as coded data S2C.

The multiplexing section 45 divides the coded data S2A to S2C into fixed-length packets and then multiplexes the packets, based on priority information S40 which is supplied from an priority information supply unit not shown. The multiplexed data is sent out to the outer encoding section 36 as a coded stream S3. Here, in the priorities represented by the priority information S40, the priority of the coded data S2C, which is obtained by encoding the text-broadcasting data S1C, is the highest. Next, the priority of the coded data S2B, which is obtained by encoding the image data S1 with the SDTV standard, and the priority of the coded data S2A, which is obtained by encoding the image data S1 with the HDTV standard, become lower in order. At this time, the multiplexing section 45 writes in the priority information S40 at the header portion of the coded stream S3. In the outer encoding section 36, the error correction by the outer code according to the priority information S40 is performed on the coded stream S3. The processes thereafter are the same as the error correction encoding-multiplexing apparatus 10 shown in Fig. 4.

In this case, as shown in Fig. 19, the coded data S2A of HDTV standard is normally decoded at the receiving side. When the C/N ratio is degraded and therefore the coded data S2A of HDTV standard cannot be decoded, the coded data S2B of SDTV standard having higher error correction ability than the data S2A of HDTV standard is decoded. Furthermore, when the C/N ratio is degraded and therefore the coded data S2A of SDTV standard cannot be decoded, the coded data S2C of the text-broadcasting data having higher error correction ability than the data S2A of SDTV standard is decoded. With this, interruption of reception due to the quality degradation of the transmission path can be prevented.

Also, in the above-mentioned embodiment, the error correction ability of each broadcasting data is set based on the priority information supplied from the priority information supply section that the transmitting side has. However, the present invention is not limited thereto and the receiving side can arbitrarily set the contents of priority information and send it to the transmitting side. At this time, the transmitting side can set the error correction ability of each broadcasting data on the basis of the priority information. That is, as shown in Fig. 20, information priority S120 is supplied to an error correction encoding-multiplexing apparatus 110 at the transmitting side from a decoder 120 at the receiving side through a line such as a telephone line or cable television (CATV). Here, a receiver arbitrary sets the priority of each broadcasting data which is represented by the priority information S120 with the decoder 120 The error correction encoding-multiplexing apparatus 110 can reliably decode the high-priority broadcasting data specified by a receiver, by performing error correction ability according to the priority information S120 onto each coded data.

Also, in the aforementioned embodiment, the error correction process by the Read-solomon method and the convolutional method is employed. However, the present invention is not limited thereto and an error correction processes by other methods can be employed.

Next, the receiver (IRD) 105 of the receiving side in the digital multiplex broadcasting system 200 in Fig. 3 will be described.

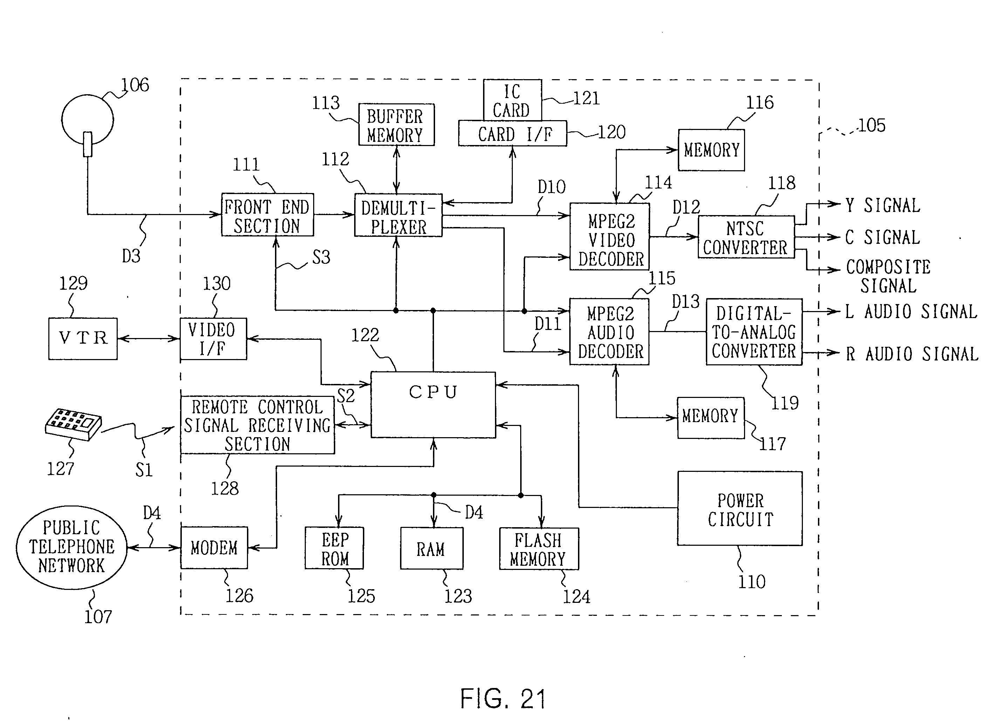

Fig. 21 denotes a receiver (IRD) 105 according to the present invention. In the receiver 105, when a power is supplied by a power circuit 110 connected to an AC outlet (not shown), via a plug to drive a central processing unit (CPU) 122, the CPU 122 performs a process according to an operation instructed by a user with a remote control 127.

The CPU 122 makes the remote control signal receiving section 128 receive a remote control signal S1 representing a channel number outputted from the remote control 127 of the user, and receives the signal S1 as a remote control signal S2. The CPU 122 generates a channel selection signal S3 according to the inputted remote control signal S2 to supply the signal S2 to a front end section 111.

The front end section 111 inputs the reception data stream D3 an antenna 106 has received, and transmits only a reception data stream D3 of a program corresponding to the channel selection signal S3, out of the reception data stream which is being transmitted from a transponder (not shown) of a communication satellite 103, to a demultiplexer 112.

The demultiplexer 112 stores the reception data stream D3 in a buffer memory 113 and then, read out code key information on a contract channel, which is stored in an IC card 121 connected thereto with a card interface (IF) 120. In the case where the code key information coincides with code key information on a program of a selected channel number, the reception data stream D3, which is stored in the buffer memory 113, is divided into a plurality of packet data on the basis of a clock signal generated inside the CPU 122.

Then, the demultiplexer 112 takes out packet data for the program of the channel number corresponding to the channel selection signal S3, and supplies packet data D10 being image data of the taken packet data to a MPEG2 video decoder 114 and moreover, supplies packet data D11 being audio data of the taken packet data to a MPEG audio decoder 115.

In this connection, the IC card 121 stores account information according to watching time of programs the user watches, together with the code key information, so that the CPU 122 reads out the account information in accordance with a transmission request of the totaling center 108 and then transmits it to the totaling center 108 via a modem 126 and a public telephone network 107.

The MPEG2 video decoder 114 stores a plurality of packet data D10 being image data into the memory 116 and then, decodes them based on a clock signal, which is generated inside the CPU 122, with MPEG2 standard to convert them into image data D12 before being compress-encoded, and transmits the data D12 to a national television system committee (NTSC) converter 118. Here, the MPEG2 video decoder 114 extracts priority information from the header part of the packet data D10 to decode the packet data D10 in accordance with the extracted information.

The NTSC converter 118 converts the image data D12 into a video signal comprising a luminance (Y) signal, a color (C) signal and a composite signal and outputs the signal, in order to display a program having the selected channel number on the screen of the monitor.

The MPEG audio decoder 115 stores a plurality of packet data D11 being audio data into the memory 117 and then, converts the data D11 into audio data D13 before being compress-encoded by decoding the data D11 with MPEG standard based on a clock signal generated inside the CPU 122 similarly to the MPEG2 video decoder 114. The data D12 is transmitted to a digital-to-analog converter 19. Note that, the MPEG audio decoder 115 also extracts priority information from the header part of the packet data Dll to decode the packet data D11 in accordance with the extracted information, similarly to the MPEG video decoder 114.

Then, the digital-to-analog converter 19 performs a digital-to-analog converting process on the audio data D13 to generate a left audio signal and a right audio signal which are analog, and outputs them via a speaker (not shown) as stereo sounds.

In this way, the receiver 105 performs a decoding based on priority information on packets being considered as a packet having high priority by the transmitting side even if transmission quality of a transmission path is degraded and thus, the receiver can reliably perform a decoding.

As described above, in the error correction encoding-multiplexing apparatus according to the present invention, input data is given the error correction code having error correction ability according to the priority of the input data. With this, input data having high priority can reliably be transmitted even if transmission quality of a transmission path is degraded, so that the receiver can perform a decoding.

While there has been described in connection with the preferred embodiments of the invention, it will be obvious to those skilled in the art that various changes and modifications may be aimed, therefore, to cover in the appended claims all such changes and modifications as fall within the true scope of the invention.

## Claims

1. An error correction encoding method of encoding input data and also, adding a prescribed error correction code, comprising the processes of:
dividing coded data which is obtained by encoding said input data, into data having a length according to priority information of said input data; and
adding said error correction code having a code length according to said priority information, every coded data divided to form a fixed-length packet consisting of said coded data divided and said error correction code.

2. The error correction encoding method according to claim 1, comprising the processes of
collecting a prescribed number of said fixed length packets to form a data block; and
performing an interleaving process for said data block unit

3. The error correction encoding method according to claim 1, wherein
said coded data is encoded so as to have a quantity of generated code according to said priority information.

4. An error correction encoding apparatus for encoding input data and also, adding a prescribed error correction code, comprising means of:
dividing coded data which is obtained by encoding said input data, into data having a length according to priority information of said input data; and
adding said error correction code having a code length according to said priority information, to each of said coded data divided to form fixed-length packets consisting of said coded data divided and said error correction code.

5. The error correction encoding apparatus according to claim 4, comprising
interleaving means for collecting a predetermined number of said fixed-length packets to form a data block and also for performing an interleaving process for said data block unit.

6. The error correction encoding apparatus according to claim 4, wherein
said coded data is encoded so as to have a quantity of generated code according to said priority information.

7. The error correction encoding apparatus according to claim 4, comprising
priority information to which said priority information according to said input data is inputted.

8. The error correction encoding apparatus according to claim 7, comprising
priority information adding means for adding said priority information taken to said coded data.

9. The error correction encoding apparatus according to claim 4, comprising
priority information generating means for generating said priority information according to said input data based on said input data.

10. The error correction encoding apparatus according to claim 9, comprising
priority information adding means for adding said priority information generated to said coded data.

11. A data transmission method of encoding input data and also, adding a prescribed error correction code, and then transmitting the coded data, comprising the steps of:
dividing coded data which is obtained by encoding said input data, into data having a length according to priority information of said input data;
adding said error correction code having a code length according to said priority information, to each of said coded data divided to form fixed-length packets consisting of said coded data divided and said error correction code;
collecting a prescribed number of said fixed-length packets to form a data block;
performing an interleaving process for each data block unit; and
transmitting said coded data interleaved.

12. A receiving method of dividing coded data into data having a length according to priority information of input data and also, adding an error correction code having a length according to said priority information for each of said coded data divided, in order to form fixed-length packets consisting of said coded data divided and said error correction code, writing in said priority information at a prescribed position of said packet, and receiving data which is transmitted after multiplexing a plurality of said packets, said receiving method comprising:
a packet extracting process of extracting a desired packet from said data multiplexed and transmitted;
a priority information extracting process of extracting said priority information from said packet extracted; and
a deciding process of decoding data of said packet on the basis of said priority information extracted.

13. The receiving method according to claim 12, comprising a deinterleaving process for deinterleaving said data received.

14. A receiver for dividing coded data into data having a length according to priority information of said input data and also, adding an error correction code having a length according to said priority information for each of said coded data divided, in order to form fixed-length packets consisting of said coded data divided and said error correction code, writing in said priority information at a prescribed position of said packet, and receiving data transmitted after multiplexing a plurality of said packets, said receiver comprising:
packet extracting means for extracting a desired packet from said data multiplexed and transmitted;
priority information extracting means for extracting said priority information from said packet extracted; and
decoding means for decoding data of said packet on the basis of said priority information extracted.

15. The receiver according to claim 14, comprising deinterleaving means for deinterleaving said data received.
